# EUROPEAN PATENT APPLICATION

(11) **EP 4 815 705 A1**
(43) Date of publication of application: **30.09.2026**
(21) Application number: 25223647.6
(22) Date of filing: 16.12.2025
(51) Int. Cl.: H10P 74/00, H10P 74/20

(54) **VOLTAGE CONTRAST FOR BACKSIDE PROCESSES ON WAFERS**

(30) Priority: 28.03.2025 US 202519093946
(71) Applicant: Intel Corporation, Santa Clara, CA 95054 (US)
(72) Inventor: O'BRIEN, Peter, Portland 97229 (US); YABLON, Joshua, Hillsboro 97124 (US); YATES, Bradley R., Portland 97229 (US); WEN, Xiao, Hillsboro 97124 (US); KOEPER, Mark, Portland 97229 (US); SIBAKOTI, Mandip, Hillsboro 97123 (US); SPRINKLE, Michael, Hillsboro 97124 (US); EDWARDS, Trenton, Tigard 97223 (US)
(74) Representative: 2SPL Patentanwälte PartG mbB

(57) **Abstract**

Test devices and methods for performing voltage contrast inspections on semiconductor device backside metallization regions are provided. Test devices can include a semiconductor device layer and a virtual ground layer.

## Description

### FIELD

Descriptions are generally related to semiconductor device manufacturing, and more particular descriptions are related to process verification and wafer testing.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Semiconductor test processes play a key role in manufacturing. Testing is important for both process development and process failure analysis during manufacturing. Backside power delivery for a semiconductor chip can allow more efficient power distribution and improve performance and logic density. Traditionally, power and input/output signaling was manufactured on the frontside of the wafer, by splitting out some of these lines and placing them on the backside of the semiconductor chip, performance limitations due to congestion can be mitigated. Backside metallization processes present new challenges and require different test processes than are available for the frontside metallization processes.

### BRIEF DESCRIPTION OF THE DRAWINGS

The figures are provided to aid in understanding the disclosure. The figures can include diagrams and illustrations of examples of structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the disclosure. Additionally, features are not necessarily illustrated relatively to scale due in part to the small sizes of some features and the desire for clarity of explanation in the figures.
**Figure 1** shows examples of test devices useful for process development and/or failure analysis for, for example, backside processes in semiconductor chips.
**Figure 2** illustrates additional examples of test devices useful for process development and/or failure analysis for, for example, backside processes in semiconductor chips.
**Figure 3** provides a virtual ground layer for test devices.
**Figure 4** shows a voltage contrast imaging system for test devices having a virtual ground layer.
**Figure 5** illustrates a process in which backside metallization is formed on a device region of a test device.
**Figure 6** shows a voltage contrast imaging system for additional test devices having a virtual ground layer.
**Figures 7A and 7B** provide example results from the backside inspection of test devices using voltage contrast imaging.
**Figure 8** describes a method for analyzing backside metallization processes using voltage contrast imaging.
**Figure 9** provides an example of a computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, optically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Flow diagrams as illustrated herein provide examples of sequences of various process actions. The flow diagrams can indicate operations to be executed by a software or firmware routine, as well as by physical operations. Operations can be performed by semiconductor processing and/or testing equipment, including computer systems that run testing protocols and operate aspects of testing equipment and systems. Although shown in a particular sequence or order, unless otherwise specified, the order of the actions can be modified. Thus, the illustrated diagrams should be understood as examples. The processes can be performed in a different order, and some actions can be performed in parallel. Additionally, one or more actions can be omitted and not all implementations may necessarily perform all actions.

Various components described can be a means for performing the operations or functions described. Components described can include software, hardware, or a combination of these. Some components can be implemented as software modules, hardware modules, special-purpose hardware (for example, application specific hardware, application specific integrated circuits (ASICs), and digital signal processors (DSPs)), embedded controllers, and/or hardwired circuitry. Other components can be semiconductor processing and/or testing equipment that is able to perform physical operations such as, for example, robotic manipulation, lithography, probing, material deposition (for example, chemical vapor deposition, atomic layer deposition, physical vapor deposition, electrodeposition, and/or sputtering), chemical mechanical planarization (CMP), and etching.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Terms such as chip, die, IC (integrated circuit) chip, IC die, microelectronic chip, microelectronic die, semiconductor die, semiconductor device, and/or semiconductor chip are interchangeable and refer to a device comprising integrated circuits that can be formed in part from semiconductor materials.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

Semiconductor chip interconnects can be created by forming a trench or though-layer via by etching a trench or via structure into a dielectric layer and filling the trench or via with metal. Dielectric layers can comprise, for example, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with gas-filled gaps or bubbles. Dielectric layers that include conductive features can be interlayer dielectric (ILD) features. In general, low-κ dielectrics exhibit a dielectric constant that is less than that of SiO₂.

The terms "package," "packaging," "IC package," or "chip package," "microelectronics package," or "semiconductor chip package" are interchangeable and generally refer to an enclosed carrier of one or more chips, in which the chips are coupled to a package substrate and encapsulated. The package substrate provides electrical interconnections between the chip(s) and other chips and/or a motherboard or other circuit board for I/O (input/output) communication and power delivery. A package with multiple chips can, for example, be a system in a package.

A package substrate generally includes dielectric layers or structures having conductive structures on, through, and/or embedded in the dielectric layers. The dielectric layers can be, for example, build-up layers. Dielectric materials include Ajinomoto build-up film (ABF), although other dielectric materials are possible. Semiconductor package substrates can have cores or be coreless. Semiconductor packages having cores can have dielectric layers such as buildup layers on more than one side of a core, such as on two opposite sides of a core. Cores can include through-core vias that contain a conductive material. Other structures or devices are also possible within a package substrate.

In-line detection of buried electrical opens and/or short defects during backside processing can significantly accelerate data collection and process design. In-line detection for shortened process flows allows backside contacts to be co-developed with a source/drain gate device layer at a faster cadence than methods that do not involve in-line detection and test device (i.e., test vehicles). Test devices are semiconductor devices that comprise a part of a full semiconductor chip. Test devices can allow more rapid and cost-effective development of processes by isolating parts of the semiconductor chip for process development and failure analysis.

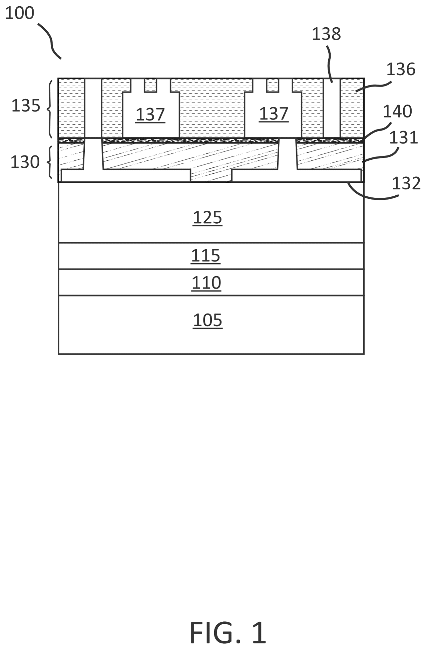

Figure 1 provides example test devices that are useful for, for example, monitoring and failure analysis of processes such as semiconductor chip backside metallization. The test device 100 includes a carrier wafer 105, a glue layer 110, an optional adhesion and/or hermeticity layer 115, and a virtual ground layer 125. The optional adhesion and/or hermeticity layer 115 can be, for example, a nitride layer. The optional adhesion and/or hermeticity layer 115 can be instead or also a bow compensation layer that aids in flattening out the wafer. The carrier wafer 105 can be comprised of a material, such as for example, silicon, silicon that includes a layer of silicon carbide (SiC), silicon dioxide (SiO₂), or silicon oxide (SiOₓ) as a bonding interface. The test device 100 can also include a metallization layer 130 and a semiconductor device layer 135. The metallization layer 130 can be a frontside metallization layer or a layer that emulates a frontside metallization layer under testing conditions or other layer that has desired properties under testing conditions. The metallization layer 130 can comprise one or more dielectric material layers 131, and conductive lines and vias 132. Although one level of conductive lines and vias 132 are shown, this region can also comprise multiple levels of conductive lines and vias 132. A semiconductor device layer can comprise transistors 137, optional conductive vias 138, and one or more dielectric layers 136. The test device 100 can comprise more than one layer of semiconductor devices 135. Semiconductor devices can also be, for example, diodes. Dielectric layers 131 and 136 can comprise, for example, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with gas-filled gaps or bubbles. The semiconductor device layer 130 can be formed on a substrate 140, such as, for example, a silicon wafer. Other substrate material are possible, as described herein.

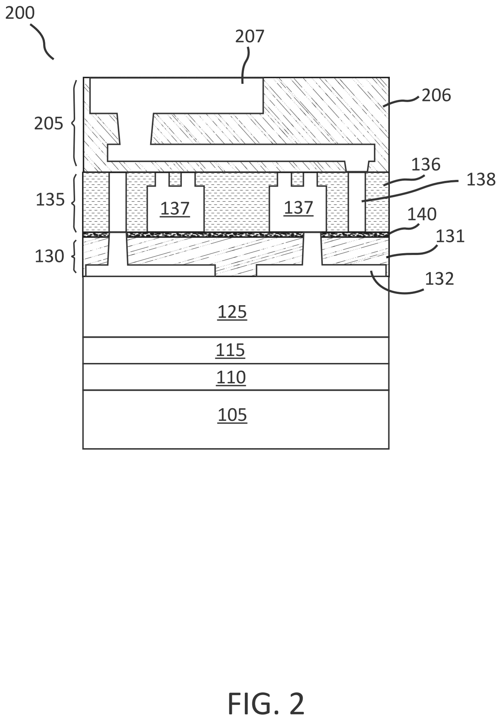

Figure 2 illustrates a test device 200 having metallization regions 130 and 205 on both a frontside and a backside, respectively, of a device region 135. Where part numbering is the same in Figure 2 as in Figure 1, descriptions for the parts in Figure 1 can be used for the same-numbered parts of Figure 2. Figure 2 also includes backside metallization region 205. Backside metallization region 205 comprises a dielectric region 206 and conductive vias and lines 207. The dielectric region 206 can be one or more layers of dielectric material, that can, for example, comprise, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with gas-filled gaps or bubbles.

The conductive vias and lines 132 and 207 and conductive vias 138 can comprise, for example, a metallic material, such as, copper (Cu), tungsten (W), and/or molybdenum (Mo).

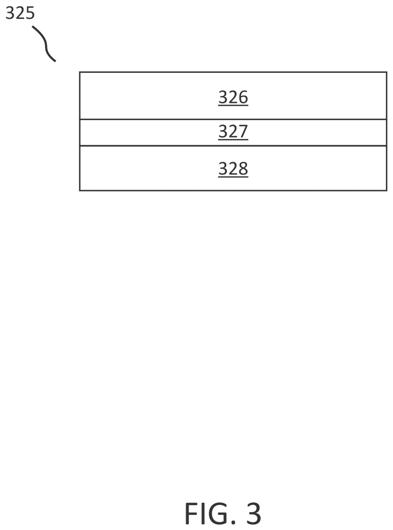

Figure 3 shows a virtual ground layer 325 that can be the virtual ground layers 125 of Figures 1 - 2. The virtual ground layer 325 can include a conformal metal layer 326, an optional adhesion layer 327, and an optional conductor or semiconductor layer 328. The conformal metal layer 326 can be comprised of tungsten (W), cobalt (Co), molybdenum (Mo), or aluminum (Al), or a combination thereof. The optional adhesion layer 327 can be comprised of, for example, titanium nitride (TiN), tantalum nitride (TaN). The optional conductor or semiconductor layer 328 can be comprised of, for example, amorphous silicon, implanted amorphous silicon in which the implanted ions can be, for example, boron, phosphorous, p or n type implanted ions, germanium, or silicon. Other implant materials are possible. A virtual ground layer 325 can prevent surface charging on the backside of a wafer comprising semiconductor chips, through capacitive coupling.

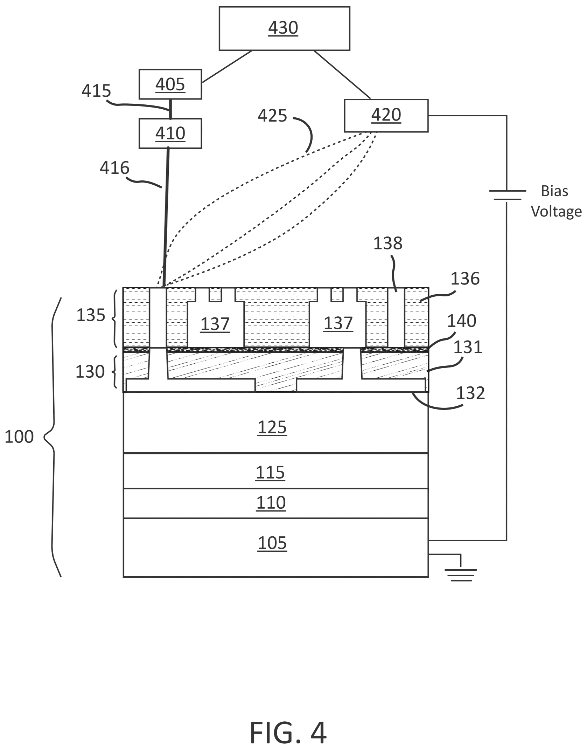

Figure 4 illustrates a system useful for inspection of the backside of a test device 100 using voltage contrast imaging (i.e., scanning electron microscopy (SEM)). A test device 100 can be the test device 100 shown and described herein with respect to Figure 1 or a different one. The test device 100 comprises a virtual ground layer 125 that can prevent surface charging and allow a voltage contrast scan to be accomplished. A voltage contrast imaging system includes a computer 430, an electron gun 405, an electron beam deflector 410, and an electron detector 420. The path of electrons emitted from the electron gun 405 is shown by lines 415 and 416. The electron detector 420 can detect secondary electrons (emitted electron path shown by a dashed line 425) from the test device surface. In general, voltage contrast imaging can use variations in surface potential for a test device and allow visualization of differences in electrical conductivity of the test device surface.

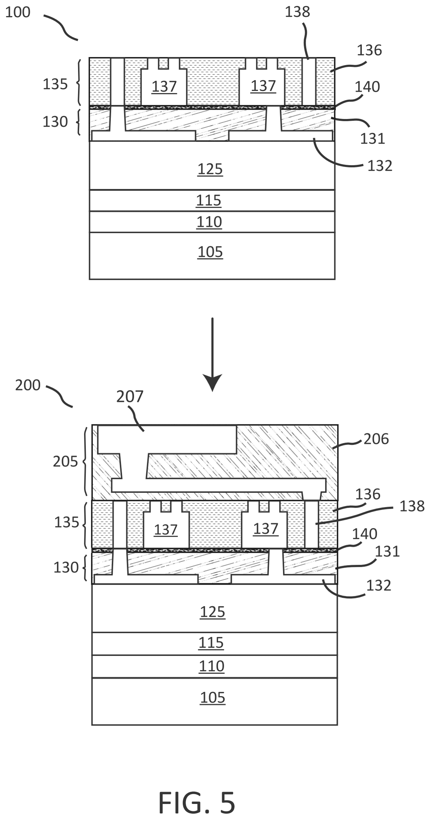

Figure 5 shows a backside metallization process that adds lines and vias 207 to a test device 100. The test device 100 can be the test device of Figure 1 or a different one. The process of Figure 5 can mimic a process of metallizing the backside of a semiconductor chip and can allow testing and failure analysis of a metallization process. A backside metallization process can include processes such as, for example, depositing one or more layers of dielectric material, etching trenches and vias, depositing liner or other materials, depositing conductive material into trenches and vias, and/or performing chemical mechanical polishing of surfaces, and optionally repeating processes to form additional metallization layers. Other processes are also possible. A metallization process flow can create the test device 200 in which a backside metallization layer has been deposited on the device region 130 of test device 100.

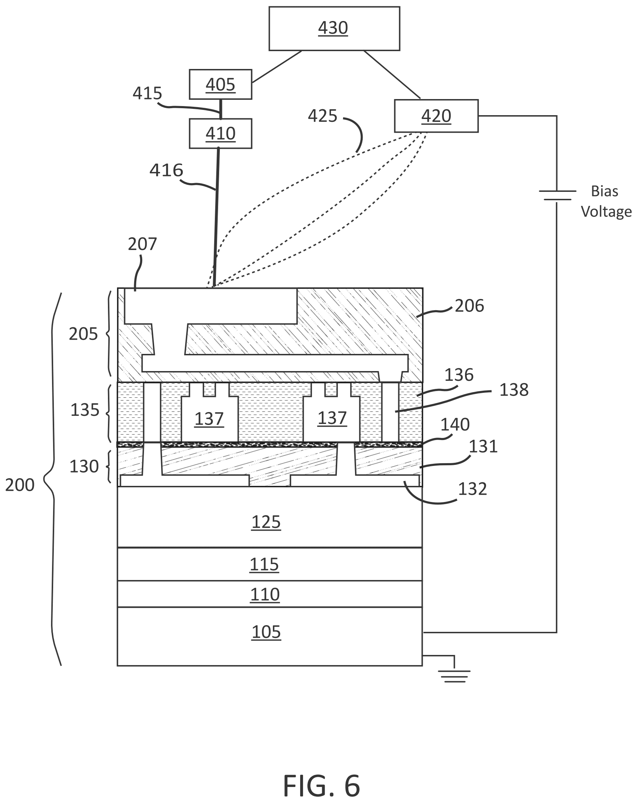

Figure 6 shows a system that can be used for inspection of the backside of a test device 200 using voltage contrast imaging. The test device 200 can be the test device of Figure 2 and/or Figure 5, or can be a different test device. Where the numbering is the same for Figure 6 as it is for Figures 4 and 2, the description for the same-numbered elements of Figures 4 and 2 can be used for Figure 6.

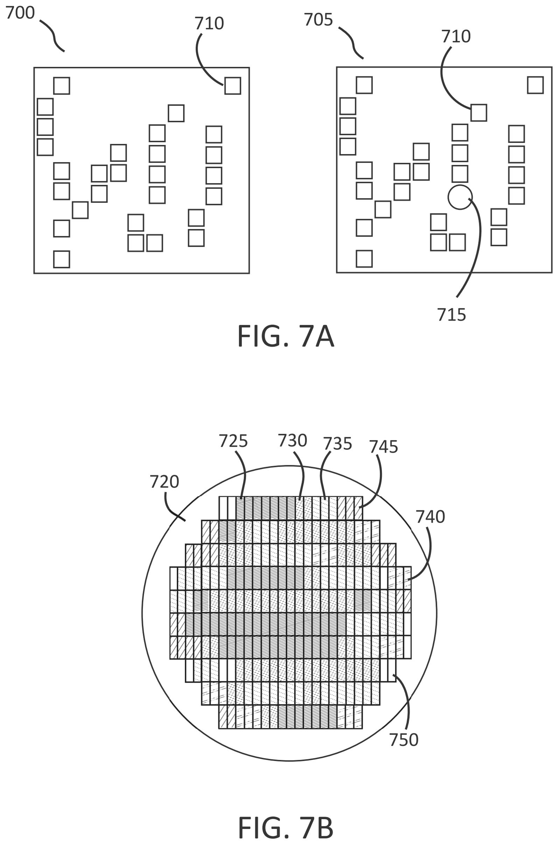

Figure 7A illustrates example results from the backside inspection of a test device using voltage contrast imaging. Example reference image 700 can be compared to example test device image 705 to identify, for example, contact open defects. Functional backside contacts can appear as bright features 710. The comparison of the reference image 700 to the test device image 705 can allow identification of a defect (highlighted by circle 715) because the defect now appears dark in the test device image 705. Figure 7B shows a map that can be created using the results of multiple wafers 720 (i.e., test devices), where colors (represented by patterns in Figure 7B), indicate relative failure counts. For example, lowest failure counts can be indicated by boxes 725, and progressively more failure counts can be indicated by boxes 730, 735, 740, 745, and 750, respectively. These results can be used to test and analyze, for example, backside metallization processes for semiconductor devices by locating failures and regions exhibiting high failure rates.

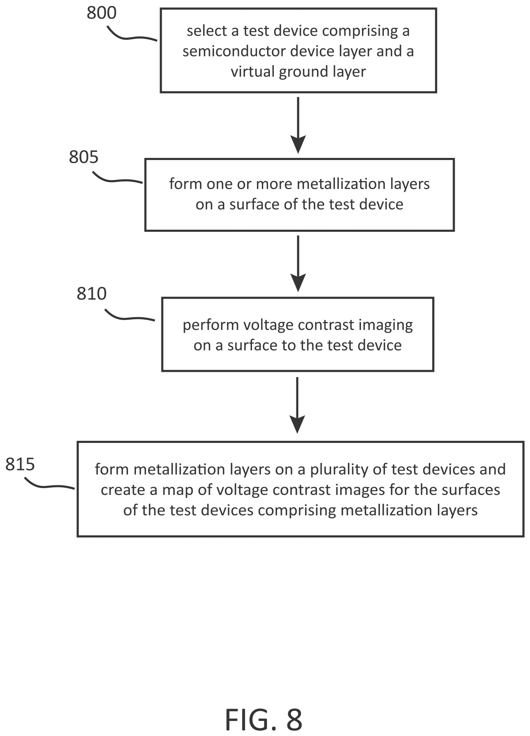

Figure 8 describes a method for analyzing backside metallization processes. A test device is selected 800. The test device can be any of the test devices as described herein, for example the test device can be the test device 100 described with respect to and shown in Figure 1. The test device can comprise a semiconductor device layer and a virtual ground layer. The test device can include a region (e.g., one that includes a semiconductor device layer and a virtual ground layer) that is attached to a substrate through a glue layer, such as, for example, an oxide glue layer. One or more metallization layers are formed on a surface of the test device 805. The metallization layer can be formed by a process that mimics the backside metallization of a semiconductor device and can comprise layers of dielectric material and conductive lines and vias in the layers of dielectric material. Voltage contrast imaging is performed on the surface of the test device comprising the one or more metallization layers 810. The voltage contrast imaging can detect defects such as opens in the metallization layers. Optionally, the elements 800 through 810 can be repeated for a plurality of test devices and a map of voltage contrast images can be created 815. The map can include indications that point to regions where the number of defects on a wafer is larger than in other areas of the wafer surface. The map can be one that is similar to the map of Figure 7B, for example.

Semiconductor device substrates can be, for example, a silicon or silicon-on-insulator substate. Other materials for semiconductor substrates include, gallium arsenide, germanium, indium antimonide, lead telluride, indium phosphide, indium antimonide, indium gallium arsenide, or gallium antimonide. Other types of substrates are also possible and the devices described herein are not limited to a particular type of substrate.

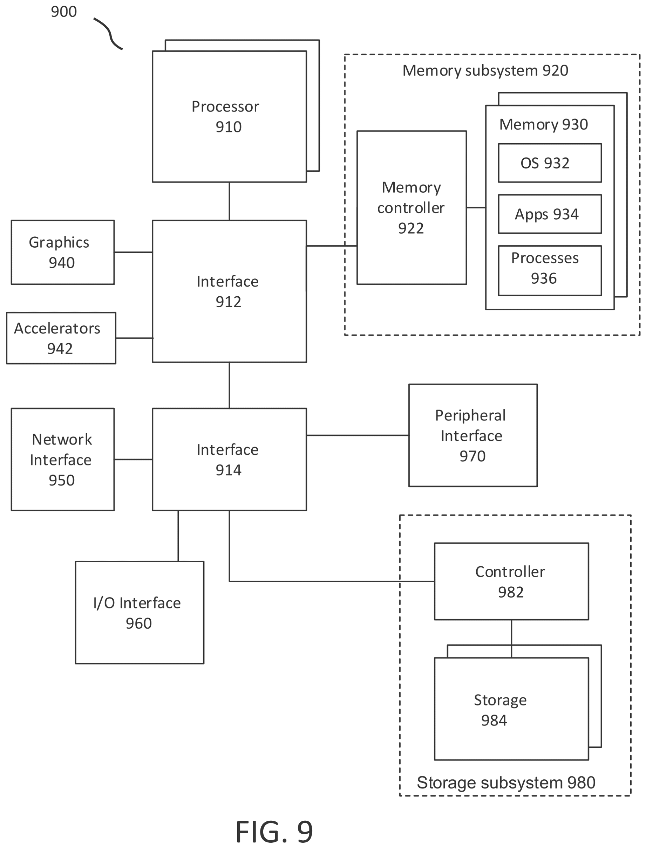

Semiconductor devices (or chips) can be any combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), HBM, and/or other memory devices. These semiconductor chip packages can be heterogeneous packages that incorporate different types of chips into one package. The semiconductor chips can be any of the chips, for example, described herein with respect to Figure 9. The semiconductor chip packages described herein generally can be part of various larger package structures and configurations and the foregoing examples are not meant to limit the types of assemblies that are possible.

Figure 9 depicts an example computing system. The computing system can be a system used for running equipment in a semiconductor fabrication plant. For example, instructions for performing one or more aspects of the process described in Figures 4, 5, 6, and/or 7A and 7B can be stored and/or run on the computing system. A computing system 900 can include more, different, or fewer features than the ones described with respect to Figure 9.

Computing system 900 includes processor 910, which provides processing, operation management, and execution of instructions for system 900. Processor 910 can include any type of microprocessor, CPU (central processing unit), GPU (graphics processing unit), processing core, or other processing hardware to provide processing for system 900, or a combination of processors or processing cores. Processor 910 controls the overall operation of system 900, and can be or include, one or more programmable general-purpose or special-purpose microprocessors, DSPs, programmable controllers, ASICs, programmable logic devices (PLDs), or the like, or a combination of such devices.

In one example, system 900 includes interface 912 coupled to processor 910, which can represent a higher speed interface or a high throughput interface for system components needing higher bandwidth connections, such as memory subsystem 920 or graphics interface components 940, and/or accelerators 942. Interface 912 represents an interface circuit, which can be a standalone component or integrated onto a processor die. Where present, graphics interface 940 interfaces to graphics components for providing a visual display to a user of system 900. In one example, the display can include a touchscreen display.

Accelerators 942 can be a fixed function or programmable offload engine that can be accessed or used by a processor 910. For example, an accelerator among accelerators 942 can provide data compression (DC) capability, cryptography services such as public key encryption (PKE), cipher, hash/authentication capabilities, decryption, or other capabilities or services. In some cases, accelerators 942 can be integrated into a CPU socket (e.g., a connector to a motherboard (or circuit board, printed circuit board, mainboard, system board, or logic board) that includes a CPU and provides an electrical interface with the CPU). For example, accelerators 942 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 942 can provide multiple neural networks, CPUs, processor cores, general purpose graphics processing units, or graphics processing units can be made available for use by artificial intelligence (Al) or machine learning (ML) models.

Memory subsystem 920 represents the main memory of system 900 and provides storage for code to be executed by processor 910, or data values to be used in executing a routine. Memory subsystem 920 can include one or more memory devices 930 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 930 stores and hosts, among other things, operating system (OS) 932 that provides a software platform for execution of instructions in system 900, and stores and hosts applications 934 and processes 936. In one example, memory subsystem 920 includes memory controller 922, which is a memory controller to generate and issue commands to memory 930. The memory controller 922 can be a physical part of processor 910 or a physical part of interface 912. For example, memory controller 922 can be an integrated memory controller, integrated onto a circuit within processor 910.

System 900 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCle) bus, a Hyper Transport or industry standard architecture (ISA) bus, a small computer system interface (SCSI) bus, a universal serial bus (USB), or a Firewire bus.

In one example, system 900 includes interface 914, which can be coupled to interface 912. In one example, interface 914 represents an interface circuit, which can include standalone components and integrated circuitry. In one example, user interface components or peripheral components, or both, couple to interface 914. Network interface 950 provides system 900 the ability to communicate with remote devices (e.g., servers or other computing devices) over one or more networks. Network interface 950 can include an Ethernet adapter, wireless interconnection components, cellular network interconnection components, USB, or other wired or wireless standards-based or proprietary interfaces. Network interface 950 can transmit data to a device that is in the same data center or rack or a remote device, which can include sending data stored in memory.

Some examples of network interface 950 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 900 includes one or more input/output (I/O) interface(s) 960. I/O interface 960 can include one or more interface components through which a user interacts with system 900 (e.g., audio, alphanumeric, tactile/touch, or other interfacing). Peripheral interface 970 can include additional types of hardware interfaces, such as, for example, interfaces to semiconductor fabrication equipment and/or electrostatic charge management devices.

In one example, system 900 includes storage subsystem 980. Storage subsystem 980 includes storage device(s) 984, which can be or include any conventional medium for storing data in a nonvolatile manner, such as one or more magnetic, solid state, and/or optical based disks. Storage 984 can be generically considered to be a "memory," although memory 930 is typically the executing or operating memory to provide instructions to processor 910. Whereas storage 984 is nonvolatile, memory 930 can include volatile memory (e.g., the value or state of the data is indeterminate if power is interrupted to system 900). In one example, storage subsystem 980 includes controller 982 to interface with storage 984. In one example controller 982 is a physical part of interface 912 or processor 910 or can include circuits or logic in both processor 910 and interface 914.

A power source (not depicted) provides power to the components of system 900. More specifically, power source typically interfaces to one or multiple power supplies in system 900 to provide power to the components of system 900.

Examples of systems may be implemented in various types of computing, smart phones, tablets, personal computers, and networking equipment, such as switches, routers, racks, and blade servers such as those employed in a data center and/or server farm environment.

A device can comprise a substrate; a virtual ground layer comprising a metallic layer and a semiconductor layer; a first metallization layer wherein the virtual ground layer is between the substrate and the first metallization layer and wherein the first metallization layer comprises dielectric layers and conductive lines and vias in the dielectric layers; and a device layer comprising semiconductor devices wherein the device layer is on the first metallization layer. The metallic layer can be comprised of tungsten, cobalt, molybdenum, or aluminum. The virtual ground layer can also include an adhesion layer. The virtual ground layer can also include a layer of titanium nitride. The device can also include an oxide glue layer attached to the substrate wherein the oxide glue layer is between a nitride layer and the substrate. The device layer can comprise semiconductor transistors. The device can include a second metallization layer comprising dielectric layers and conductive lines and vias in the dielectric layers wherein the first and the second metallization layers are on opposite sides of the device layer.

A method can comprise: forming a backside metallization region on a surface of a test device, wherein the backside metallization region includes conductive regions and dielectric regions; wherein the test device can comprise: a substrate; a virtual ground layer comprising a metallic layer and a semiconductor layer; a frontside metallization layer wherein the virtual ground layer is between the substrate and the frontside metallization layer and wherein the frontside metallization layer comprises dielectric layers and conductive lines and vias in the dielectric layers; and a device layer comprising semiconductor devices; and performing a voltage contrast inspection of the metallization region wherein the voltage contrast inspection allows determination of operability of conductive regions in the metallization region. The metallic layer can be comprised of tungsten, cobalt, molybdenum, or aluminum. The virtual ground layer can also include an adhesion layer. The virtual ground layer can also include a layer of titanium nitride. The test device can also include an oxide glue layer attached to the substrate. The device layer can comprise semiconductor transistors. The backside metallization region can comprise a plurality of dielectric layers and a plurality of conductive lines and vias in the plurality of dielectric layers.

At least one machine-readable storage medium can comprise non-transitory instructions, that when executed by a processor, cause a system to: form a backside metallization region on a surface of a test device, wherein the backside metallization region includes conductive regions and dielectric regions; wherein the test device can comprise: a substrate; a virtual ground layer comprising a metallic layer and a semiconductor layer; a frontside metallization layer wherein the virtual ground layer is between the substrate and the frontside metallization layer and wherein the frontside metallization layer comprises dielectric layers and conductive lines and vias in the dielectric layers; and a device layer comprising semiconductor devices; and perform a voltage contrast inspection of the metallization region wherein the voltage contrast inspection allows determination of operability of conductive regions in the metallization region. The metallic layer can be comprised of tungsten, cobalt, molybdenum, or aluminum. The virtual ground layer can also include a layer of titanium nitride. The test device can also include an oxide glue layer attached to the substrate. The device layer can comprise semiconductor transistors. The backside metallization region can comprise a plurality of dielectric layers and a plurality of conductive lines and vias in the plurality of dielectric layers.

Besides what is described herein, various modifications can be made to what is disclosed and implementations without departing from their scope. Therefore, the illustrations and examples herein should be construed in an illustrative, and not a restrictive sense.

## Claims

1. A device comprising:
a substrate;
a virtual ground layer comprising a metallic layer and a semiconductor layer;
a first metallization layer wherein the virtual ground layer is between the substrate and the first metallization layer and wherein the first metallization layer comprises dielectric layers and
conductive lines and vias in the dielectric layers; and
a device layer comprising semiconductor devices wherein the device layer is on the first metallization layer.

2. The device of claim 1, wherein the metallic layer is comprised of tungsten, cobalt, molybdenum, or aluminum.

3. The device of one of the previous claims, wherein the virtual ground layer also includes an adhesion layer.

4. The device of one of the previous claims, wherein the virtual ground layer also includes a layer of titanium nitride.

5. The device of one of the previous claims, also including an oxide glue layer attached to the substrate wherein the oxide glue layer is between a nitride layer and the substrate.

6. The device of one of the previous claims, wherein the device layer comprises semiconductor transistors.

7. The device of one of the previous claims, also including a second metallization layer comprising dielectric layers and conductive lines and vias in the dielectric layers wherein the first and the second metallization layers are on opposite sides of the device layer.

8. A method comprising:
forming a backside metallization region on a surface of a test device, wherein the backside metallization region includes conductive regions and dielectric regions; wherein the test device comprises:
a substrate;
a virtual ground layer comprising a metallic layer and a semiconductor layer;
a frontside metallization layer wherein the virtual ground layer is between the substrate and the frontside metallization layer and wherein the frontside metallization layer comprises dielectric layers and conductive lines and vias in the dielectric layers; and
a device layer comprising semiconductor devices; and
performing a voltage contrast inspection of the metallization region wherein the voltage contrast inspection allows determination of operability of conductive regions in the metallization region.

9. The method of claim 8, wherein the metallic layer is comprised of tungsten, cobalt, molybdenum, or aluminum.

10. The method of claim 8 or 9, wherein the virtual ground layer also includes an adhesion layer.

11. The method of one of the claims 8-10, wherein the virtual ground layer also includes a layer of titanium nitride.

12. The method of one of the claims 8-11, wherein the test device also includes an oxide glue layer attached to the substrate.

13. The method of one of the claims 8-12, wherein the device layer comprises semiconductor transistors.

14. The method of one of the claims 8-13, wherein the backside metallization region comprises a plurality of dielectric layers and a plurality of conductive lines and vias in the plurality of dielectric layers.

15. At least one machine-readable storage medium comprising non-transitory instructions, that when executed by a processor, cause a system to:
form a backside metallization region on a surface of a test device, wherein the backside metallization region includes conductive regions and dielectric regions; wherein the test device comprises:
a substrate;
a virtual ground layer comprising a metallic layer and a semiconductor layer;
a frontside metallization layer wherein the virtual ground layer is between the substrate and the frontside metallization layer and wherein the frontside metallization layer comprises dielectric layers and conductive lines and vias in the dielectric layers; and
a device layer comprising semiconductor devices; and
perform a voltage contrast inspection of the metallization region wherein the voltage contrast inspection allows determination of operability of conductive regions in the metallization region.
